(19) Europäisches Patentamt
European Patent Office
Office européen des brevets

(11) **EP 4 749 877 A1**

(12) **EUROPEAN PATENT APPLICATION**
published in accordance with Art. 153(4) EPC

(43) Date of publication:
**27.05.2026 Bulletin 2026/22**

(21) Application number: **24907878.3**

(22) Date of filing: **29.11.2024**

(51) International Patent Classification (IPC):
**H02J 7/00** (2026.01)    **G01R 31/392** (2019.01)
**H02J 1/10** (2026.01)

(52) Cooperative Patent Classification (CPC):
**G01R 31/392; H02J 1/10; H02J 7/00**

(86) International application number:
**PCT/KR2024/019392**

(87) International publication number:
**WO 2025/135593 (26.06.2025 Gazette 2025/26)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **21.12.2023 KR 20230188796**
**25.11.2024 KR 20240170006**

(71) Applicant: **LG Energy Solution, Ltd.**
**Seoul 07335 (KR)**

(72) Inventors:
• **KIM, Seung-Choo**
**Daejeon 34122 (KR)**
• **KIM, Myung-Hwan**
**Daejeon 34122 (KR)**
• **RYU, Je-Chang**
**Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **POWER SUPPLY CONTROL APPARATUS AND POWER SUPPLY CONTROL METHOD**

(57)    There are provided a power supply control apparatus and a power supply control method. The power supply control apparatus according to the present disclosure includes a measurement unit to generate measurement data indicating a state of each of a plurality of power supply modules, a monitoring unit to generate monitoring information including at least one of aging level information and load factor information based on the measurement data, and a main control unit to control each of the plurality of power supply modules into an operating mode or a non-operating mode based on the monitoring information.

FIG. 1

# EP 4 749 877 A1

**Description**

<u>TECHNICAL FIELD</u>

The present disclosure relates to technology for individual operation mode control of a plurality of power supply modules.

This application is based on and claims priority from Korean Patent Application No. 10-2023-0188796 filed on December 21, 2023 and Korean Patent Application No. 10-2024-0170006 filed on November 25, 2024, with the Korean Intellectual Property Office, the disclosures of which are incorporated herein in its entirety by reference.

<u>BACKGROUND</u>

A power supply that supplies power to an electrical load (for example, at least one battery charger/discharger) may include an assembly of a plurality of power supply modules connected in parallel, in order to solve problems with heat generation and failed systematic response to fault diagnosis as well as achieve more stable power supply to the electrical load.

Electric vehicles, ships and large-capacity energy storage systems (ESS) are more likely to raise safety accident prevention and stable power supply issues, and thus they usually include such power supply modules.

The power supply including the plurality of power supply modules may have various advantages of high scalability in keeping up with increasing load, higher space utilization than a single large-capacity power supply module, robustness against failures and errors and no need to shut off the power supply to the electrical load during replacement of the individual power supply module.

Typically, the power supply modules that make up the power supply are electrically connected in parallel to the electrical load and configured to supply the power to the electrical load through relay control.

This type of power supply is generally managed in a manner that adjusts the number of individual power supply modules according to the scale or magnitude of the power to be supplied, i.e., by a control method that sequentially increases the number of power supply modules in operating mode with increasing load. As a consequence, the conventional power supply cannot avoid a situation in which the life deviation between the power supply modules increases so much.

Accordingly, the conventional power supply may not have a grave problem while in use for a short time, but as the power supply is used for a longer time, the life deviation between some power supply modules that do more work and the other power supply modules gradually increases.

When the life deviation is too large, it may have a great influence on the operation performance or life of the individual power supply modules, and the characteristics and performance of the power supply modules connected in parallel may greatly differ, causing performance degradation of the power supply system such as declines in total available output.

<u>DISCLOSURE</u>

<u>Technical Problem</u>

The present disclosure is designed to solve the above-described problems under these circumstances, and therefore the present disclosure is directed to providing a power supply control apparatus and method for suppressing life deviations between power supply modules that make up a power supply, improving the operation performance of the power supply and effectively increasing the life, based on continuous and cyclic monitoring results of the aging level of the individual power supply modules.

The technical problems to be solved by the present disclosure are not limited to the aforementioned problems, and these and other problems will be clearly understood by those skilled in the art from the following description.

<u>Technical Solution</u>

A power supply control apparatus according to an aspect of the present disclosure includes a measurement unit to generate measurement data indicating a state of each of first to n-th power supply modules provided to supply direct current power to an electrical device; a monitoring unit to generate monitoring information including at least one of aging level information and load factor information based on the measurement data, wherein among first to n-th aging levels of the aging level information, an i-th aging level indicates an aging level of an i-th power supply module among the first to n-th power supply modules, and among first to n-th load factors of the load factor information, an i-th load factor indicates a load factor of the i-th power supply module; and a main control unit to control each of the first to n-th power supply modules into

2

an operating mode or a non-operating mode based on the monitoring information. n is a natural number of 2 or greater, and i is a natural number of n or smaller.

The monitoring unit may be configured to determine a temperature change amount of the i-th power supply module during a unit time based on the measurement data. The monitoring unit may be configured to determine an aging level increase value of the i-th power supply module based on the temperature change amount. The monitoring unit may be configured to determine the i-th aging level based on the aging level increase value and a previous aging level of the i-th power supply module.

The monitoring unit may be configured to determine the aging level increase value of the i-th power supply module based on relationship data between a temperature rise and the aging level when the temperature change amount indicates the temperature rise of the i-th power supply module.

The monitoring unit may be configured to determine the aging level increase value of the i-th power supply module based on relationship data between a temperature drop and the aging level when the temperature change amount indicates the temperature drop of the i-th power supply module.

The main control unit may be configured to classify each power supply module in the operating mode among the first to n-th power supply modules into a first group. The main control unit may be configured to classify each power supply module in the non-operating mode among the first to n-th power supply modules into a second group.

When a largest aging level deviation of the first group is equal to or more than a reference aging level deviation, the main control unit may be configured to determine any one power supply module of the first group as a first target module, determine any one power supply module of the second group as a second target module, switch the second target module from the non-operating mode to the operating mode, and switch the first target module from the operating mode to the non-operating mode.

When the first group includes two or more power supply modules, the main control unit may be configured to determine any one power supply module having a highest aging level among the two or more power supply modules as the first target module.

When the second group includes two or more power supply modules, the main control unit may be configured to determine any one power supply module having a longest idle time among the two or more power supply modules of the second group as the second target module.

The main control unit may be configured to switch any one power supply module of the second group from the non-operating mode to the operating mode when the load factor of the first group exceeds an upper limit of a reference load factor range.

The main control unit may be configured to switch any one power supply module having a highest aging level in the first group from the operating mode to the non-operating mode when the load factor of the first group is less than a lower limit of a reference load factor range.

A direct current power supply system according to another aspect of the present disclosure includes the power supply control apparatus.

A power supply control method according to still another aspect of the present disclosure includes generating measurement data indicating a state of each of first to n-th power supply modules provided to supply direct current power to an electrical device; generating monitoring information including at least one of aging level information or load factor information based on the measurement data, wherein among first to n-th aging levels of the aging level information, an i-th aging level indicates an aging level of an i-th power supply module among the first to n-th power supply modules, and among first to n-th load factors of the load factor information, an i-th load factor indicates a load factor of the i-th power supply module; and controlling each of the first to n-th power supply modules into an operating mode or a non-operating mode based on the monitoring information. n is a natural number of 2 or greater, and i is a natural number of n or smaller.

The step of generating the monitoring information may include determining a temperature change amount of the i-th power supply module during a unit time based on the measurement data; determining an aging level increase value of the i-th power supply module based on the temperature change amount; and determining the i-th aging level based on the aging level increase value and a previous aging level of the i-th power supply module.

The step of controlling each of the first to n-th power supply modules into the operating mode or the non-operating mode may include classifying each power supply module in the operating mode among the first to n-th power supply modules into a first group; and classifying each power supply module in the non-operating mode among the first to n-th power supply modules into a second group.

The step of controlling each of the first to n-th power supply modules into the operating mode or the non-operating mode may further include switching any one power supply module of the second group from the non-operating mode to the operating mode when the load factor of the first group exceeds an upper limit of a reference load factor range.

The step of controlling each of the first to n-th power supply modules into the operating mode or the non-operating mode may further include switching any one power supply module having a highest aging level in the first group from the operating mode to the non-operating mode when the load factor of the first group is less than a lower limit of a reference load factor range.

Advantageous Effects

According to at least one of the embodiments of the present disclosure, as time-dependent changes in the aging level of the individual power supply modules included in the power supply are used to control the operation mode of each of the power supply modules, it may be possible to prevent excessive increases in aging level deviation between the power supply modules.

Additionally, according to at least one of the embodiments of the present disclosure, as the load factor of the power supply module in the operating mode lies in the reference load factor by stopping at least one operating power supply module or activating at least one non-operating power supply module, it may be possible to minimize power losses caused by too high or low load factors.

Additionally, according to at least one of the embodiments of the present disclosure, in case where there is a need to reverse the operation mode of two power supply modules while the power supply modules are being controlled into different operation modes, any one power supply module in the non-operating mode may be switched to the operating mode and the other power supply module in the operating mode may be switched to the non-operating mode, thereby preventing temporary shortage of direct current power supply to the electrical device when the two power supply modules are all in the non-operating mode.

According to at least one of the embodiments of the present disclosure, as the aging level deviations between the plurality of power supply modules are suppressed, there is a low failure frequency advantage of the individual power supply modules during the lifespan of the direct current power supply system. That is, it may be possible to contribute to high Mean Time To Failure (MTTF), and the Mean Time Between Failure (MTBF) can be made to approach MTTF.

The effects of the present disclosure are not limited to the aforementioned effects, and these and other effects will be clearly understood by those skilled in the art from the appended claims.

BRIEF DESCRIPTION OF THE DRAWINGS

The accompanying drawings illustrate the exemplary embodiments of the present disclosure and serve to provide a more effective understanding of the technical aspect of the present disclosure together with the following detailed description, and thus the present disclosure should not be constructed as being limited to the drawings.

FIG. 1 is a diagram schematically showing a configuration of a power supply system according to an embodiment of the present disclosure.
FIG. 2 is a diagram schematically showing a configuration of a power supply control apparatus shown in FIG. 1.
FIG. 3 is a block diagram schematically showing a detailed configuration of a power supply control apparatus shown in FIG. 1.
FIG. 4 is a flowchart illustrating a power supply control method according to an embodiment of the present disclosure.
FIG. 5 is a block diagram showing a detailed configuration of a main control unit shown in FIG. 3.
FIG. 6 is a flowchart exemplarily showing subroutines that may be performed in step S430 of FIG. 4.
FIG. 7 is a flowchart exemplarily showing subroutines that may be performed in step S650 of FIG. 6.
FIGS. 8 and 9 are flowcharts illustrating a power supply control method according to another embodiment of the present disclosure.
FIG. 10 is a diagram referenced in exemplarily describing time-dependent changes in operation mode of a plurality of power supply modules.
FIG. 11 is a flowchart exemplarily showing subroutines that may be performed in step S420 of FIG. 4.

BEST MODE

Hereinafter, the exemplary embodiment of the present disclosure will be described in detail with reference to the accompanying drawings. Prior to the description, the terms or words used in the specification and the appended claims should not be construed as being limited to general and dictionary meanings, and rather, should be interpreted based on the meanings and concepts corresponding to the technical aspect of the present disclosure on the basis of the principle that the inventor is allowed to define the terms appropriately for the best explanation.

Therefore, the embodiments described herein and the illustrations shown in the drawings are provided to describe the technical aspect of the present disclosure for illustrative purposes but not intended to be limiting, so it should be understood that a variety of other equivalents and modifications could have been made thereto at the time the application was filed.

The terms "first", "second" and the like, are used to distinguish one element from another among various elements, and are not intended to limit the elements by the terms.

Unless the context clearly indicates otherwise, the terms "comprise" and "include" when used in this specification, specify the presence of stated elements, but do not preclude the presence or addition of one or more other elements. Furthermore, the term "unit" as used herein refers to a processing unit of at least one function or operation, and may be implemented by either hardware or software or a combination thereof.

In addition, throughout the specification, it should be further understood that when an element is referred to as being "connected to" another element, it may be directly connected to the other element or intervening elements may be present.

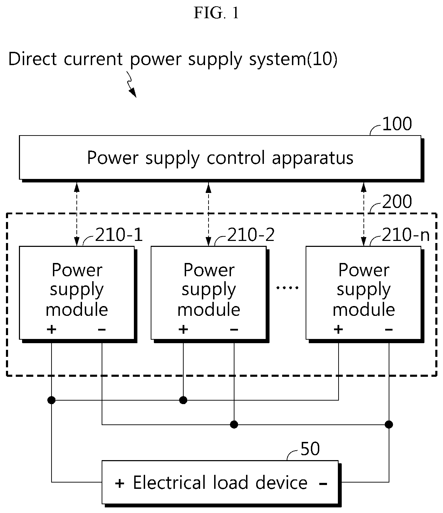

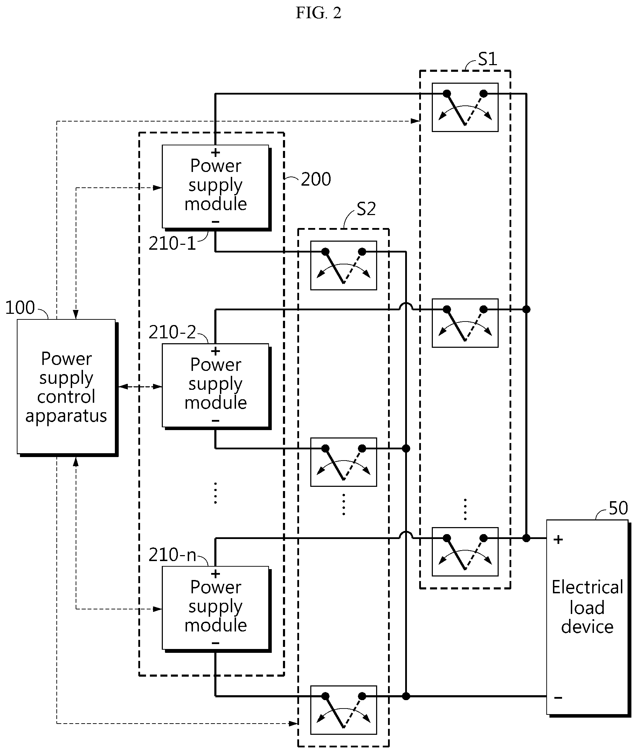

FIG. 1 is a diagram schematically showing a configuration of a power supply system according to an embodiment of the present disclosure, and FIG. 2 is a diagram schematically showing a configuration of a power supply control apparatus 100 shown in FIG. 1.

Referring to FIGS. 1 and 2, the power supply system 10 includes an electrical load device 50, the power supply control apparatus 100 and a power supply 200.

The electrical load device 50 is a load using electricity as a power source and is supplied with power from the power supply 200. The electrical load device 50 may include, for example, at least one battery charger/discharger in a battery manufacturing plant. The electrical load device 50 may be the term used to refer collectively to various electrical devices, electrical equipment or electrical facilities.

The power supply control apparatus 100 manages and controls the operation of the power supply 200 that supplies direct current power to the electrical load device 50.

The power supply 200 may include first to n-th power supply modules 210-1 to 210-n. Here, n denotes a natural number of 2 or greater. When i is a natural number of n or smaller, the reference numeral 210-i indicates an i-th power supply module. Hereinafter, in the common description to the power supply modules 210-1 to 210-n, it should be noted that the reference numeral 210 may be affixed to the power supply module.

FIG. 2 shows an example of a wiring relationship between the first to n-th power supply modules 210-1 to 210-n and the electrical load device 50, required for the direct current power supply from the first to n-th power supply modules 210-1 to 210-n to the electrical load device 50.

As shown in FIG. 2, each of the first to n-th power supply modules 210-1 to 210-n may be connected to the power supply control apparatus 100 through a control line. The control line connected between the i-th power supply module 210-i and the power supply control apparatus 100 corresponds to a signal channel for control signal transmission from the power supply control apparatus 100 to the i-th power supply module 210-i.

Additionally, each of the first to n-th power supply modules 210-1 to 210-n may be connected to the electrical load device 50 through a pair of power lines.

The power supply control apparatus 100 may further include at least one of a first switching circuit S1 or a second switching circuit S2. The first switching circuit S1 may include a plurality of switches installed on the power line between a first power terminal (for example, a plus terminal) of the first to n-th power supply modules 210-1 to 210-n and a first power terminal of the electrical load device 50. The second switching circuit S2 may include a plurality of switches installed on the power line between a second power terminal (for example, a minus terminal) of the first to n-th power supply modules 210-1 to 210-n and a second power terminal of the electrical load device 50. In FIGS. 1 and 2, the symbol + indicates the first power terminal, and the symbol - indicates the second power terminal.

When the switches of the first switching circuit S1 installed on the first power line and the switches of the second switching circuit S2 installed on the second power line are selectively and individually turned on and off by the control of the power supply control apparatus 100, at least one of the first to n-th power supply modules 210-1 to 210-n may supply power to the power supply 200.

The wiring relationship between the components shown in FIG. 2 is provided by way of example. Accordingly, any other designs and configurations for the direct current power supply to the electrical load device 50 from the first to n-th power supply modules 210-1 to 210-n connected in parallel may be contemplated.

The power supply module 210 may be implemented through any one of known power conversion devices for converting alternating current (AC) power into direct current (DC) power or adjusting the voltage level of DC power, such as, for example, AC/DC converters, DC/DC converters, transformers or smoothing circuits, or a combination thereof.

Hereinafter, the detailed configuration of the power supply control apparatus 100 and the operation performed by each component will be described in detail with reference to the accompanying drawings.

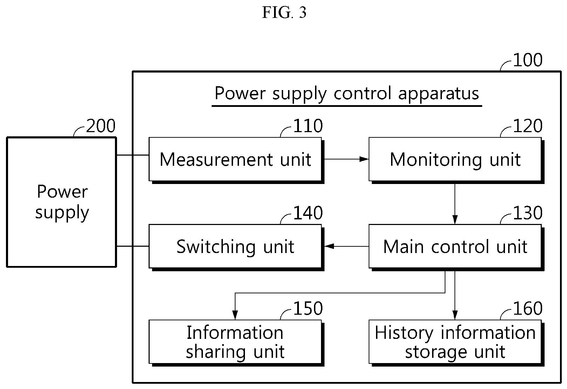

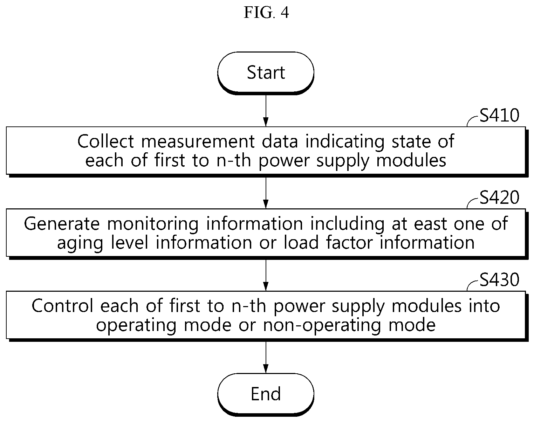

FIG. 3 is a block diagram schematically showing the detailed configuration of the power supply control apparatus 100 shown in FIG. 1, and FIG. 4 is a flowchart illustrating a power supply control method according to an embodiment of the present disclosure.

Referring to FIGS. 3 and 4, the power supply control apparatus 100 may include a measurement unit 110, a monitoring unit 120 and a main control unit 130. The power supply control apparatus 100 may further include at least one of a switching unit 140, an information sharing unit 150 and a history information storage unit 160.

The measurement unit 110 may measure at least one type of state parameter (for example, direct current power, voltage, current, temperature) indicating the state of each of the first to n-th power supply modules 210. To this end, the measurement unit 110 may include n power measurement circuits (for example, watt-meters) and n temperature measurement circuits (for example, thermistors) to individually measure the power and temperature of the first to n-th power supply modules 210-1 to 210-n.

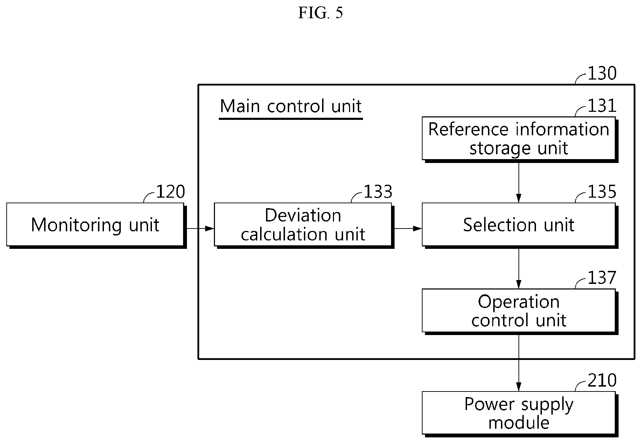

At least one of the components of the power supply control apparatus 100 may be implemented through a variety of combinations of electronic devices or components (ASIC, chipset, logic circuit, register, communication modem, MCU, etc.) such as storage means, calculation processing means or input/output means. Accordingly, it should be understood that each component of the power supply control apparatus 100 shown in FIG. 3 can be distinguished from other component physically, functionally and/or logically. The same is the case with each component of the main control unit 130 shown in FIG. 5.

That is, each component shown in the drawings corresponds to the logical component for effectively describing the technical aspect of the present disclosure, so it should be interpreted that each component carrying out the function performed by the logical component of the present disclosure either separately or together falls within the scope of the present disclosure, and it should be further interpreted that the components performing the same or similar functions fall within the scope of the present disclosure irrespective of whether or not the names are exactly the same.

In addition, the power supply control method according to the present disclosure may be implemented by a set of processes or algorithms related to data processing, manipulation, control, calculation or input/output, and thus, it may be implemented by a combination of logical components shown in FIG. 3 as well as in the form of software that is installed and runs on a system, a device, a computer (or its similar device), a battery management system (BMS), a module or lower level components thereof.

The switching unit 140 may include at least one of the first switching circuit S1 or the second switching circuit S2 described above with reference to FIG. 2.

In step S410, the measurement unit 110 may generate measurement data indicating the state of each of the first to n-th power supply modules 210. The measurement unit 110 may measure at least one type of state parameter (for example, direct current power, voltage, current, temperature) of each of the first to n-th power supply modules 210-1 to 210-n, and the measurement data may include measurement values for each state parameter. The measurement data may be collected by the monitoring unit 120.

The temperature measurement circuit provided in the power supply module 210 includes at least one temperature sensor. In relation to this, the power supply module 210 includes a variety of electrical devices such as an input terminal, an output terminal, a field effect transistor (FET), a capacitor, a transformer or an electric line. When the power supply module 210 operates in an operating mode, heat is generated from each electrical device, causing degradation of each electrical device. In addition, each electrical device may differ in thermal conductivity and the extent of thermal expansion, causing cracks in certain parts of the power supply module 210 where mechanical stress concentration occurs.

When the temperature measurement circuit includes a plurality of temperature sensors, each temperature sensor may measure the temperature of a specific electrical device or a specific area of the power supply module 210. The temperature (or measured temperature value) of the power supply module 210 indicated by the measurement data may be the average of temperature values measured by the plurality of temperature sensors.

In step S420, the monitoring unit 120 may generate monitoring information including at least one of aging level information or load factor information based on the measurement data collected from the measurement unit 110. The aging level information includes first to n-th aging levels. An i-th aging level indicates the aging level of the i-th power supply module 210-i. The load factor information includes first to n-th load factors. An i-th load factor indicates the load factor of the i-th power supply module 210-i.

When it is assumed that the sum of the aging level and the remaining life of the power supply module 210 is a predetermined value, aging level determination may be understood as remaining life determination. The monitoring unit 120 may transmit data notifying the aging level of each power supply module 210 to the main control unit 130.

In this specification, the operation time of the power supply module 210 may refer to the total amount of time (summed up, accumulated) the power supply module 210 has operated in the operating mode for a period of time from a specific time in the past to the current time. The specific time in the past may be, for example, the time when the power supply module 210 was first used to supply direct current power to the electrical load device 50 after it was mounted on the direct current power supply system 10.

The monitoring unit 120 may generate and record parameter history information indicating time-dependent changes in the state parameter of the power supply module 210 using the measurement data collected from the measurement unit 110.

Additionally, the monitoring unit 120 may identify if the power supply module 210 is in operation. The monitoring unit 120 may be configured to generate (update) operation time information of the power supply module 210 in operation.

The monitoring unit 120 may determine the aging level of the power supply module 210 based on the parameter history information and the operation time information of the power supply module 210. The process for determining the aging level may be repeated in a predetermined cycle by using clock setting, or may be repeated each time a switching event of the operation mode of the power supply module 210 occurs. The method for determining the aging level will be described in detail below.

In step S430, the main control unit 130 controls each of the first to n-th power supply modules 210-1 to 210-n into an operating mode or a non-operating mode based on the monitoring information. The step S430 provides at least one of a technical advantage of suppressing the aging level deviation between the first to n-th power supply modules 210-1 to 210-n or a technical advantage of improving the efficiency of power supply to the electrical load device 50.

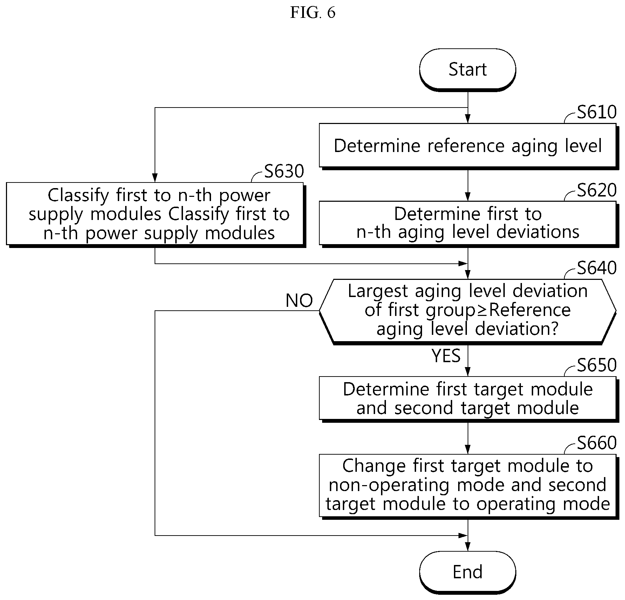

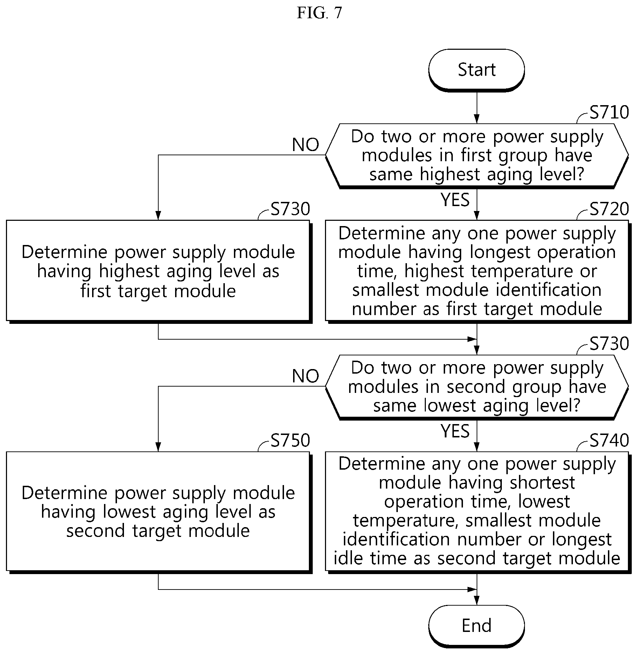

FIG. 5 is a block diagram showing a detailed configuration of the main control unit shown in FIG. 3, FIG. 6 is a flowchart exemplarily showing subroutines that may be performed in the step S430 of FIG. 4, and FIG. 7 is a flowchart exemplarily showing subroutines that may be performed in step S650 of FIG. 6.

Referring to FIG. 5, the main control unit 130 may include a reference information storage unit 131, a deviation calculation unit 133, a selection unit 135 and an operation control unit 137.

The reference information storage unit 131 may store a reference aging level deviation. The reference aging level deviation may indicate the maximum allowable aging level deviation for the first to n-th power supply modules 210-1 to 210-n.

The reference aging level deviation may be a predetermined fixed value. Alternatively, the reference aging level deviation may be variably set, taking into account attribute information such as power consumption of the electrical load device 50 connected to the power supply 200, and specification information such as discharge rate and discharge capacity of the power supply module 210.

In step S610, the deviation calculation unit 133 may determine a reference aging level based on the aging level information inputted from the monitoring unit 120. The deviation calculation unit 133 may determine the reference aging level based on first to n-th aging levels by executing statistical calculation (for example, see Equations 1 and 2 below) to the aging level information indicating the first to n-th aging levels inputted from the monitoring unit 120. The reference aging level may refer to, for example, the arithmetic mean, weighted mean or harmonic mean of the first to n-th aging levels.

In step S620, the deviation calculation unit 133 may determine first to n-th aging level deviations indicating differences between the first to n-th aging levels and the reference aging level, respectively. An i-th aging level deviation may indicate a difference between the i-th aging level and the reference aging level.

The process of determining the aging level deviation may be repeatedly performed periodically or aperiodically while at least one of the first to n-th power supply modules 210-1 to 210-n is controlled into the operating mode. Its detailed embodiment will be described below.

The deviation calculation unit 133 may generate the aging level deviation of each of the first to n-th power supply modules 210-1 to 210-n by calculating the difference between each of the first to n-th aging levels and the reference aging level.

<Equation 1>

$$A = \frac{1}{n}\sum_{k=1}^{n} T_k$$

<Equation 2>

$$\sigma_k = T_k - A$$

In Equations 1 and 2, $T_k$ denotes a k-th aging level, A denotes the reference aging level, and $\sigma_k$ denotes a k-th aging level deviation, respectively. The k-th aging level deviation $\sigma_k$ indicates a difference between the k-th aging level $T_k$ and the reference aging level A.

The selection unit 135 may identify which of the operating or non-operating mode each of the first to n-th power supply modules 210-1 to 210-n is. The operating mode refers to a mode of direct current power supply to the electrical load device 50. The non-operating mode refers to a mode that stops the direct current power supply to the electrical load device 50.

In step S630, the selection unit 135 may classify the first to n-th power supply modules 210-1 to 210-n into a first group and a second group according to the operation mode of each of the first to n-th power supply modules 210-1 to 210-n. That is, each of the first to n-th power supply modules 210-1 to 210-n may be classified into the first group or the second group. The first group includes the power supply module 210 operating in the operating mode. The second group includes the power supply module 210 operating in the non-operating mode.

Step S430, etc. as described below may be performed on the condition that at least one power supply module 210 is included in the first group and at least one power supply module 210 is included in the second group. That is, when all the first to n-th power supply modules 210-1 to 210-n are only classified into any one of the first group and the second group, the method according to FIG. 4 may not be performed.

In step S640, the selection unit 135 may determine if the largest aging level deviation of the first group is equal to or more than the reference aging level deviation. The largest aging level deviation of the first group may indicate the largest value of the aging level deviations of the power supply modules belonging to the first group. When the value of the step S640 is "YES", step S650 may be performed.

In step S650, the selection unit 135 determines a first target module in the first group and determines a second target module in the second group. The first target module may be any one power supply module 210 having the highest aging level in the first group. The second target module may be any one power supply module 210 in the second group.

In step S660, the operation control unit 137 may switch the first target module to the non-operating mode and the second target module to the operating mode. The operation control unit 137 may transmit a control signal for switching from non-operating to operating mode to the second target module. In addition, the operation control unit 137 may transmit a control signal for switching from operating to non-operating mode to the first target module. When the second target module is switched to the operating mode, the second target module takes responsibility for direct current power supply to the electrical load device 50 in place of the first target module switched to the non-operating mode.

Each of the remaining power supply modules 210 other than the first target module and the second target module may maintain the operation at the time when the method of FIG. 6 is performed.

When the value of the step S640 is "NO", the method according to FIG. 6 may end. The first group including no power supply module 210 having the aging level deviation equal to or more than the reference aging level deviation may signify that severe aging level imbalance does not occur in the power supply modules belonging to the first group.

Because the operation mode and operation time of the power supply module 210 change over time, the state and aging level of each of the first to n-th power supply modules 210-1 to 210-n change over time as well.

The present disclosure may repeat the determination and control of the first target module and the second target module during the operation of the direct current power supply system 10. Accordingly, although the total use of the direct current power supply system 10 increases over time, the largest aging level deviation of the first to n-th power supply modules 210-1 to 210-n included in the power supply 200 may be maintained below the reference aging level deviation.

Meanwhile, in relation to the step S660, the operation control unit 137 may output the control signal for changing the first target module from the operating mode to the non-operating mode after a dead band time has passed from the output time of the control signal for changing the second target module from the non-operating mode to the operating mode.

When digital signal systems are created using analog signals, the values of the output signals may have values between 0 and 1 over a short period of time. For example, during the dead band time, the signal level of the control signal transmitted to the second target module increases from 0 to 1, and the second target module may be switched from the non-operating mode to the operating mode on the condition that the signal level of the input signal is equal to or more than a threshold. When the first target module is switched to the non-operating mode before the second target module is switched to the operating mode, there is a short period of time during which the first target module and the second target module are all in the non-operating mode, causing a sudden reduction in power supply to the electrical load 50.

Accordingly, the present disclosure may output the control signal for driving the first target module to operate in the non-operating mode after the dead band time has passed from the output time of the control signal for driving the second target module to operate in the operating mode, thereby effectively reducing ambiguity arising from changes in signal level and preventing unintentional stop in the power supply from both the first target module and the second target module to the electrical load device 50.

The method according to FIG. 7 may be performed when each of the first group and the second group includes two or more power supply modules 210.

Referring to FIG. 7, in step S710, the selection unit 135 determines if the two or more power supply modules 210 in the first group have the same highest aging level. The value of the step S710 being "YES" may signify that the aging levels of the two or more power supply modules 210 included in the first group are the same and the aging level is highest in the first group. When the value of the step S710 is "YES", step S720 may be performed. The value of the step S710 being "NO" may signify that there is only one power supply module 210 having the highest aging level in the first group. When the value of the step S710 is "NO", step S730 may be performed.

In step S720, the selection unit 135 determines, as the first target module, any one power supply module 210 having the longest operation time, the highest temperature or the smallest module identification number among the two or more power supply modules 210 having the same highest aging level.

In step S730, the selection unit 135 determines any one power supply module 210 having the highest aging level as the first target module.

In step S740, the selection unit 135 determines if the two or more power supply modules 210 in the second group have the same lowest aging level. The value of the step S740 being "YES" may signify that the aging levels of the two or more power supply modules 210 included in the second group are the same and the aging level is lowest in the second group. When the value of the step S740 is "YES", step S750 may be performed. The value of the step S740 being "NO" may signify that there is only one power supply module 210 having the lowest aging level in the second group. When the value of the step S740 is "NO", step S750 may be performed.

In step S740, the selection unit 135 determines, as the second target module, any one power supply module 210 having the shortest operation time, the lowest temperature, the highest-ranked module identification number or the longest idle time among the two or more power supply modules 210 having the same lowest aging level. The idle time of the power supply module 210 may refer to the elapsed time from the latest switching time of the power supply module 210 from the operating mode to the non-operating mode.

In step S750, the selection unit 135 determines any one power supply module 210 having the lowest aging level as the second target module.

By the above-described procedures, in addition to the aging level of each power supply module 210 belonging to the first group, further considering at least one of the operation time or the temperature, any one power supply module 210 having the lowest performance in the first group may be selected as the first target module. Further, in addition to the aging level of each power supply module 210 belonging to the second group, further considering at least one of the operation time, the temperature or the idle time, any one power supply module 210 having the highest performance in the second group may be selected as the second target module. Accordingly, the first target module having lower power supply performance may be changed to the non-operating mode, and the second target module having higher power supply performance may be changed to the non-operating mode, thereby improving the overall operation stability of the direct current power supply system 10 and increasing the life.

The first to n-th aging levels of the first to n-th power supply modules 210-1 to 210-n, the reference aging level and the first to n-th aging level deviations change over time. Accordingly, to suppress the aging level deviations between the first to n-th power supply modules 210-1 to 210-n, there is a need to update related data so that these changes may be cyclically reflected in the control of the power supply module 210. The history information indicating time-dependent changes in the state, aging level, aging level deviation, operation time, operation mode (i.e., operating mode or non-operating mode) of the power supply module 210 may be stored in the history information storage unit 160. The history information stored in the history information storage unit 160 may be used in the subsequent process.

The aging level information newly generated each time the method of FIG. 4 is performed may be recorded in the history information storage unit 160. According to embodiments, the aging level information stored at the previous timing may be replaced with the aging level information newly generated at the current timing. Alternatively, to increase the efficiency of statistical operations or application processes, the aging level information may be accumulated by combining the previous aging level information with the current aging level information.

Hereinafter, the process of maintaining the load factor of the power supply module 210 belonging to the first group among the first to n-th power supply modules 210-1 to 210-n, i.e., the power supply module 210 being controlled into the operating mode within a reference load factor range will be described.

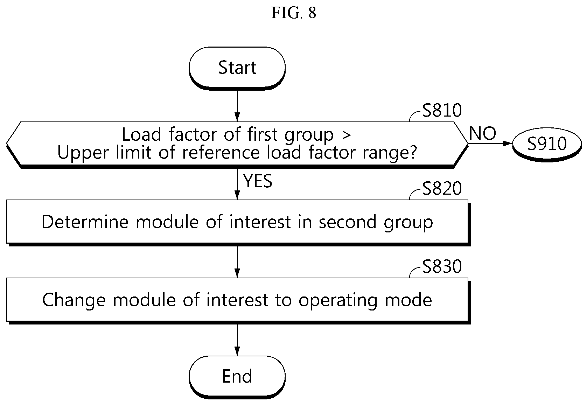

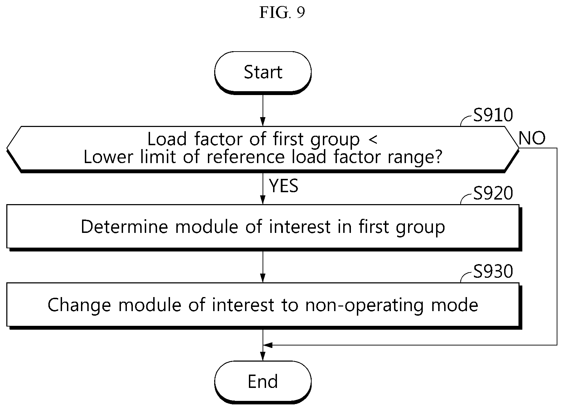

FIGS. 8 and 9 are flowcharts illustrating the power supply control method according to another embodiment of the present disclosure. The method according to each of FIGS. 8 and 9 may be a set of subroutines that may be included in the step S430 of FIG. 4.

The method according to FIGS. 8 and 9 may be performed on the condition that the size of the second group is equal to or larger than 1, i.e., at least one of the first to n-th power supply modules 210-1 to 210-n is classified into the second group.

In step S810, the selection unit 135 may determine if the load factor of the first group exceeds the upper limit of the reference load factor range.

The reference information storage unit 131 may store reference load factor data. The reference load factor data may indicate the preset reference load factor range for a predetermined level or more of input/output efficiency of the power supply module 210.

The reference load factor range may be utilized to maintain the direct current power output from the power supply module 210 within an optimal range. The reference load factor may be shared among the first to n-th power supply modules 210-1 to 210-n. The maximum output power (also referred to as 'rated power') may be shared among the first to n-th power supply modules 210-1 to 210-n.

The upper limit of the reference load factor range refers to a ratio of maximum allowable power to maximum output power. The lower limit of the reference load factor range refers to a ratio of minimum allowable power to maximum output power. That is, while the power supply module 210 is controlled into the operating mode, the direct current power supplied from the power supply module 210 to the electrical load device 50 may be adjusted between the maximum allowable power and the minimum allowable power.

The load factor of the power supply module 210 refers to a ratio of direct current power output from the power supply module 210 at the current time to maximum output power. For example, when the maximum output power is 20 kW and the upper limit of the reference load factor range is set to 70%, it is necessary to control the direct current power output from the power supply module 210 below 14 kW.

When the load factor of the power supply module 210 in the operating mode is lower than the lower limit of the reference load factor range or higher than the upper limit, the input/output efficiency of the power supply module 210 may fall short of the predetermined level. Accordingly, there is a need for a process of adjusting the direct current power output from the power supply module 210 so that the load factor of the power supply module 210 in the operating mode lies within the reference load factor range.

When the value of the step S810 is "YES", step S820 may be performed. When the value of the step S810 is "NO", step S910 may be performed.

In step S820, the selection unit 135 determines a module of interest in the second group. The determined module of interest in the second group may be any one power supply module 210 having the lowest aging level or the longest idle time in the second group.

In step S830, the operation control unit 137 switches the determined module of interest in the second group to the operating mode. For example, the operation control unit 137 may transmit the control signal that triggers the switch from non-operating to operating mode to the determined module of interest in the second group.

For example, assume that the upper limit of the reference load factor is 70%, the maximum output power output is 20 kW, and four power supply modules 210-1 to 210-4 are currently operating in the operating mode. When power consumption of the electrical load device 50 is 50 kW, each power supply module 210 supplies the power of 50 kW/4 = 12.5 kW to the electrical load device 50. In this example, the load factor of each of the power supply modules 210-1 to 210-4 is 12.5 kW/20 kW = 62.5%. Because 62.5% does not exceed the upper limit of the reference load factor range, it may not be necessary to determine which of the power supply modules 210 will be changed to the operating mode in the second group.

In this case, when the aging level deviation of at least one of the four power supply modules 210-1 to 210-4 in the operating mode is equal to or more than the reference aging level deviation, the procedure for stopping the operation of the first target module and the procedure for starting the operation of the second target module may be performed.

In contrast, in the case that the four power supply modules 210-1 to 210-4 belong to the first group, when power consumption of the electrical load device 50 increases from 50 kW to 72 kW, each of the four power supply modules 210-1 to 210-4 supplies the equal direct current power of 16.0 kW. Accordingly, the load factor of the four power supply modules 210-1 to 210-4 increases from 62.5% to 80%, and exceeds the reference load factor. In this case, the selection unit 135 may determine the module of interest from the second group, and accordingly, the operation control unit 137 may control the module of interest into the operating mode.

When the determined module of interest in the second group is changed from the non-operating mode to the operating mode, the module of interest may be removed from the second group and added to the first group. That is, each of the first group and the second group may be updated.

When power consumption of the electrical load device 50 is 72 kW, and the determined module of interest in the second group starts the power supply to the electrical load device 50 together with the four power supply modules 210-1 to 210-4, the size of the first group may increase by 1 from 4 to 5. For reference, the size of a group may refer to the total number of members (i.e., power supply modules) belonging to the group. As a result, each of the five power supply modules belonging to the first group supplies the power of 72 kW/5 = 14.4 kW to the electrical load device 50. In this case, the load factor of each power supply module 210 of the first group decreases to 14.4 kW/20 kW = 72%, but is still larger than the reference load factor of 70%.

Those skilled in the art will easily understand that the method according to FIGS. 8 and 9 may be repeatedly performed periodically or aperiodically, and the load factor of each power supply module 210 belonging to the first group will be adjusted below the reference load factor of 70%.

For example, when the size of the first group increases by 1 from 5 to 6, each of the six power supply modules supplies the power of 72 kW/6 = 12.0 kW to the electrical load device 50. Accordingly, the load factor of each of the six power supply modules is as low as 12.0 kW/20 kW = 60%, and the power supply modules may be changed to a stable load state in which the load factor is below the upper limit (70%) of the reference load factor range.

Meanwhile, when the maximum output power output is 20 kW and the lower limit of the reference load factor range is set to 40%, the direct current power output from each power supply module 210 of the first group needs to be controlled to exceed 8 kW.

For reference, the method according to FIG. 9 may be performed on the condition that the size of the first group is equal to or larger than 2. When the load factor of the first group is equal to or less than the upper limit of the reference load factor range, step S910 may be performed. In step S910, the selection unit 135 may determine if the load factor of each power supply module 210 belonging to the first group is less than the lower limit of the reference load factor range. When the value of the step S910 is "YES", step S920 may be performed. When the value of the step S910 is "NO", the method according to FIG. 9 may end.

For example, assume that the lower limit of the reference load factor range is 40%, the maximum output power output is 20 kW, and the four power supply modules 210-1 to 210-4 are classified into the first group.

When power consumption of the electrical load device 50 is 50 kW, each power supply module of the first group supplies the equal power of 12.5 kW to the electrical load device 50. Because the load factor of each power supply module 210 is 12.5 kW/20 kW = 62.5% above the lower limit of 40% of the reference load factor range, it may not be necessary to determine which of the four power supply modules 210-1 to 210-4 will be changed to the non-operating mode. In this case, the value of the step S910 is "NO".

In contrast, when power consumption of the electrical load device 50 decreases from 50 kW to 30 kW, each of the four power supply modules 210-1 to 210-4 supplies the equal power of 7.5 kW to the electrical load device 50, and the load factor of each power supply module 210 of the first group decreases to 37.5% below the reference load factor. In this case, the value of the step S910 is "YES".

In step S920, the selection unit 135 may determine a module of interest in the first group. The determined module of interest in the first group may be any one power supply module 210 having the highest aging level in the first group.

In step S930, the operation control unit 137 may change the determined module of interest in the first group to the non-operating mode. That is, the second module of interest may be switched from the operating mode to the non-operating mode in response to the control signal transmitted from the operation control unit 137.

When the step S930 is performed, the size of the first group decreases by 1, while the size of the second group increases by 1. In addition, in relation to the above-described example, each of the three power supply modules maintained as the first group supplies the equal power of 30 kW/3 = 10 kW to the electrical load device 50. In this case, the load factor of each power supply module of the first group increases from 37.5% to 50% and lies in between the lower limit (40%) and the upper limit (70%) of the reference load factor range.

Despite the size reduction of the first group from 4 to 3, when the load factor of the first group is below the lower limit of the reference load factor range, the method according to FIG. 9 may be performed again.

As described above, the present disclosure may avoid excessive increases in the aging level deviation between the first to n-th power supply modules 210-1 to 210-n through the cyclic application of the process of determining the first target module, the second target module and/or the module of interest among the first to n-th power supply modules 210-1 to 210-n based on at least one of the operation time or the load factor of each of the first to n-th power supply modules 210-1 to 210-n, and controlling the switching of each power supply module between the operating mode and the non-operating mode. As a result, there are advantages of contributing to longer life of the direct current power supply system 10 and reducing the frequency of replacement of the power supply module 210.

Even in a situation in which all the first to n-th power supply modules 210-1 to 210-n are classified into the first group (i.e., the size of the second group = 0), the load factor of the power supply module 210 may exceed the reference load factor. In this case, the information sharing unit 150 may generate alarm information and transmit the generated alarm information to a pre-registered device such as a user terminal, an automotive info system or a control server. The alarm information may notify the user that an overload has occurred. This may lead the user to take a follow-up action in the dangerous situation in a timely manner.

The method according to FIG. 6 may be performed on the condition that both the values of the steps S810 and S910 of the method according to FIGS. 8 and 9 are "NO". The values of the steps S810 and S910 being "NO" signify that the load factor of the first group lies within the reference load factor range.

Alternatively, the method according to FIGS. 8 and 9 may be performed on the condition that the value of the step S640 of the method according to FIG. 6 is "NO".

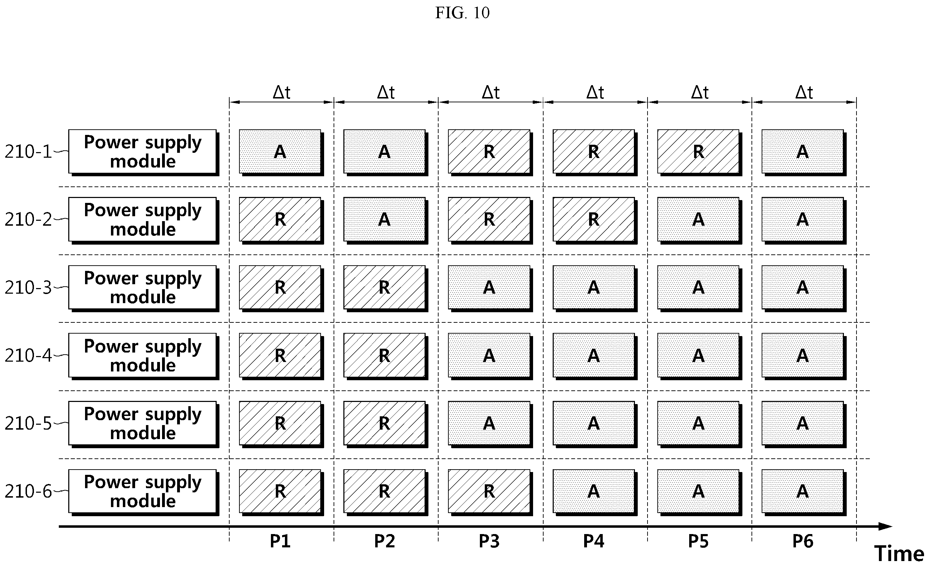

FIG. 10 is a diagram referenced in exemplarily describing time-dependent changes in operation mode of the plurality of power supply modules.

In FIG. 10, it is assumed that the power supply 200 includes a total of six power supply modules 210-1 to 210-6. FIG. 10 shows the representation of the switching of each of the six power supply modules 210-1 to 210-6 between the operating mode and the non-operating mode over time during the operation of the direct current power supply system 10. For reference, in FIG. 10, the symbol A indicates the operating mode, and the symbol R indicates the non-operating mode (idle state).

The first to sixth time intervals P1 to P6 may be separated on the basis of the time at which the switching event between the operating mode and the non-operating mode occurs in at least one of the power supply modules 210-1 to 210-6.

In describing FIG. 10, it is assumed that the aging level, the operation time and the idle time of all the power supply modules 210-1 to 210-6 are the same at the start time of the first time interval P1.

As shown, in the first time interval P1, among the power supply modules 210-1 to 210-6, only the first power supply module 210-1 is operating in the operating mode, and the remaining power supply modules 210-2 to 210-6 are operating in the non-operating mode.

When the load factor of the first power supply module 210-1 is larger than the upper limit of the reference load factor range in the first time interval P1, any one of the remaining power supply modules 210-2 to 210-6 belonging to the second group may be determined as the module of interest.

When the second power supply module 210-2 in the non-operating mode is changed to the operating mode, the first time interval P1 ends and the second time interval P2 begins.

In the second time interval P2, the second power supply module 210-2 supplies direct current power to the electrical load device 50 together with the first power supply module 210-1 in the second time interval P2. Accordingly, during the second time interval P2, the two power supply modules 210-1, 210-2 belong to the first group, while the remaining power supply modules 210-3, 210-4, 210-5, 210-6 belong to the second group.

In the second time interval P2, assume that the aging level deviation of both the first and second power supply modules 210-1, 210-2 reached the reference aging level deviation. Thus, it is necessary to select at least one power supply module that will operate in the operating mode from among the remaining power supply modules 210-3, 210-4, 210-5, 210-6 in place of the two power supply modules 210-1, 210-2. FIG. 10 shows a situation in which each of three power supply modules 210-3, 210-4, 210-5 is selected as the second target module, and each of two power supply modules 210-1, 210-2 is selected as the first target module. While the three power supply modules 210-3, 210-4, 210-5 are switched from the non-operating mode to the operating mode, the first and second power supply modules 210-1, 210-2 are switched from the operating mode to the non-operating mode, and accordingly the third time interval P3 begins.

In the third time interval P3, the load factors of the power supply modules 210-3, 210-4, 210-5 may exceed the upper limit of the reference load factor range. Thus, the module of interest may be selected from among the remaining power supply modules 210-1, 210-2, 210-6. Because the sixth power supply module 210-6 which has been controlled into the non-operating mode across the first to third time intervals P1 to P3 will have the longest idle time, the sixth power supply module 210-6 may be determined as the module of interest. Accordingly, during the fourth time interval P4, four power supply modules 210-3 to 210-6 operate in the operating mode, while two power supply modules 210-1, 210-2 are maintained in the non-operating mode.

In the fourth time interval P4, the load factor of the four power supply modules 210-3 to 210-6 exceeds the reference load factor, at least one of the two power supply modules 210-1, 210-2 in the non-operating mode is switched to the operating mode. FIG. 10 shows that the second power supply module 210-2 having lower aging level than the first power supply module 210-1 is selected as the module of interest. Accordingly, in the fifth time interval P5, the second to sixth power supply modules 210-2 to 210-6 may operate in the operating mode together, and the first power supply module 210-1 may operate in the non-operating mode.

In the fifth time interval P5, the load factors of the second to sixth power supply modules 210-2 to 210-6 may exceed the upper limit of the reference load factor range again. In this case, to reduce the load factor, it is necessary to change at least one power supply module of the second group to the operating mode. In FIG. 10, in the fifth time interval P5, only the sixth power supply module 210-6 is in the non-operating mode. Accordingly, the sixth power supply module 210-6 is determined as the module of interest, and when the sixth power supply module 210-6 operates in the operating mode, the sixth time interval P6 begins.

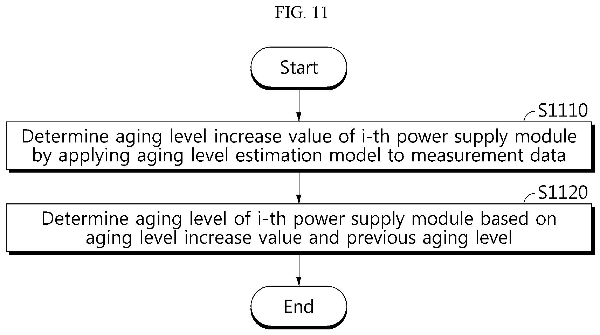

FIG. 11 is a flowchart exemplarily showing the subroutines that may be performed in the step S420 of FIG. 4. The method of FIG. 11 may be used to generate the aging level information. For convenience of description, assumes that the measurement data and the operation time information are repeatedly generated (or updated) every predetermined unit time.

In step S1110, the monitoring unit 120 may determine an aging level increase value of the i-th power supply module 210-i by applying an aging level estimation model to the measurement data. When the i-th power supply module 210-i is operating in the non-operating mode, the method of FIG. 11 may not be performed on the i-th power supply module 210-i.

The aging level estimation model used to determine the aging level increase value may be a predetermined function based on the Arrhenius equation that describes the dependence of the aging rate on temperature. Equation 3 below is an example of the aging level estimation model.

<Equation 3>

$$\Delta P_i(t) = \left( A_1 \times e^{-\frac{B}{T_{av\_i}(t)}} \right) \times dt$$

In Equation 3, $\Delta P_i(t)$ is the aging level increase value, and each of $A_1$, B and n is a preset constant. dt is the unit time (i.e., the preset time length value). $T_{av\_i}(t)$ denotes an average temperature of the i-th power supply module 210-i over a period of time from the initial operation time of the i-th power supply module 210-i to the time t. For reference, the time t may be the present time, and the unit of temperature may be Kelvin (K).

Equations 4 and 5 below are another example of the aging level estimation model.

<Equation 4>

$$\Delta P_i(t) = \left( \Delta T_i^{\,n} \times A_2 \times e^{-\frac{C}{T_{av\_i}(t)}} \right) \times dt$$

<Equation 5>

$$\Delta P_i(t) = \left( \Delta T_i^{\,n} \times A_3 \times e^{-\frac{D}{T_{av\_i}(t)}} \right) \times dt$$

In Equations 4 and 5, $\Delta T_i$ is a temperature change amount (may be an absolute value) of the i-th power supply module 210-i during the unit time, each of $A_2$, $A_3$, C and D is a preset constant, and the remaining variables are the same as the variables in Equation 3.

Equation 4 is an example of relationship data between temperature rise and aging level, and may be used when the temperature of the i-th power supply module 210-i rises during the unit time. For reference, with the increasing rate at which the temperature of the power supply module 210 rises, the expansion level of at least a part of the power supply module 210 may increase, leading to faster aging.

On the contrary, Equation 5 is an example of relationship data between temperature drop and aging level, and may be used when the temperature of the i-the power supply module 210-i drops during the unit time. For reference, with the increasing rate at which the temperature of the power supply module 210 drops, the shrinkage level of at least a part of the power supply module 210 may increase, leading to faster aging.

The required variables in Equations 3 to 5 may be calculated by the monitoring unit 120. Equations 3 to 5 should be understood as some examples for describing the aging level estimation model, and the aging level estimation model is not limited to Equations 3 to 5. That is, the aging level estimation model may include any other function that mathematically represents a positive correspondence relationship between the temperature-related variable(s) and the aging level increase value.

The constants in Equations 3 to 5 may be preset through data fitting, taking into account simulation or pre-test results, and may be tunable values.

In step S1120, the monitoring unit 120 determines the i-th aging level (current aging level) of the i-th power supply module 210-i based on the aging level increase value and the previous aging level of the i-th power supply module 210-i.

To determine the i-th aging level of the i-th power supply module 210-i, Equation 6 or 7 below may be used.

<Equation 6>

$$P_i(t) = \sum_{k=1}^{j} \Delta P_i(dt \times k)$$

<Equation 7>

$$P_i(t) = P_i(t - dt) + \Delta P_i(t)$$

In Equations 6 and 7, $P_i(t)$ is the aging level of the i-th power supply module 210-i, and $P_i(t\text{-}dt)$ is the previous aging level of the i-th power supply module 210-i. j is a count index corresponding to the time t, and may be a value obtained by dividing the period of time from the initial operation time of the i-th power supply module 210-i to the time t by dt.

The aging level increase value indicates how much the aging level increases during the unit time. Accordingly, the current aging level of the i-th power supply module 210-i may be determined by repeatedly summing up the aging level increase values newly determined at each unit time or adding the aging level increase value determined in the step S1110 to the previous aging level.

When the procedures described above with reference to FIG. 11 are individually performed on the first to n-th power supply modules 210-1 to 210-n, the aging level of each of the first to n-th power supply modules 210-1 to 210-n may be determined.

The embodiments of the present disclosure as described above are not embodied only through the apparatus and method, and may be implemented through programs that perform the functions corresponding to the exemplary configurations of the present disclosure or recording media having the programs recorded thereon, and such implementation may be easily achieved by those skilled in the art from the disclosure of the embodiments previously described.

Although the present disclosure has been hereinabove described with regard to certain embodiments and drawings, the present disclosure is not limited thereto and it is obvious to those skilled in the art that various modifications and changes may be made thereto within the technical aspect of the present disclosure and the scope of the appended claims and their equivalents.

Additionally, as many substitutions, modifications and changes may be made to the present disclosure as described above by those skilled in the art without departing from the technical aspect of the present disclosure, the present disclosure is not limited by the above-described embodiments and the accompanying drawings, and some or all of the embodiments may be selectively combined to allow various modifications.

**Claims**

1. A power supply control apparatus comprising:

    a measurement unit configured to generate measurement data indicating a state of each of first to n-th power supply modules provided to supply direct current power to an electrical load device;
    a monitoring unit configured to generate monitoring information including at least one of aging level information and load factor information based on the measurement data, wherein among first to n-th aging levels of the aging level information, an i-th aging level indicates an aging level of an i-th power supply module among the first to n-th power supply modules, and among first to n-th load factors of the load factor information, an i-th load factor indicates a load factor of the i-th power supply module; and
    a main control unit configured to control each of the first to n-th power supply modules into an operating mode or a non-operating mode based on the monitoring information,
    wherein n is a natural number of 2 or greater, and i is a natural number of n or smaller.

2. The power supply control apparatus according to claim 1,
   wherein the monitoring unit is configured to:

    determine a temperature change amount of the i-th power supply module during a unit time based on the measurement data,
    determine an aging level increase value of the i-th power supply module based on the temperature change amount, and
    determine the i-th aging level based on the aging level increase value and a previous aging level of the i-th power supply module.

3. The power supply control apparatus according to claim 2,
   wherein the monitoring unit is configured to:

    determine the aging level increase value of the i-th power supply module based on relationship data between a temperature rise and the aging level when the temperature change amount indicates the temperature rise of the i-th power supply module, and
determine the aging level increase value of the i-th power supply module based on relationship data between a temperature drop and the aging level when the temperature change amount indicates the temperature drop of the i-th power supply module.

4. The power supply control apparatus according to claim 1,
wherein the main control unit is configured to:

classify each power supply module in the operating mode among the first to n-th power supply modules into a first group, and
classify each power supply module in the non-operating mode among the first to n-th power supply modules into a second group.

5. The power supply control apparatus according to claim 4,
wherein when a largest aging level deviation of the first group is equal to or more than a reference aging level deviation, the main control unit is configured to:

determine any one power supply module of the first group as a first target module, and determine any one power supply module of the second group as a second target module,
switch the second target module from the non-operating mode to the operating mode, and
switch the first target module from the operating mode to the non-operating mode.

6. The power supply control apparatus according to claim 5,
wherein when the first group includes two or more power supply modules, the main control unit is configured to:
determine any one power supply module having a highest aging level among the two or more power supply modules as the first target module.

7. The power supply control apparatus according to claim 5,
wherein when the second group includes two or more power supply modules, the main control unit is configured to:
determine any one power supply module having a longest idle time among the two or more power supply modules of the second group as the second target module.

8. The power supply control apparatus according to claim 4,
wherein the main control unit is configured to:
switch any one power supply module of the second group from the non-operating mode to the operating mode when the load factor of the first group exceeds an upper limit of a reference load factor range.

9. The power supply control apparatus according to claim 4,
wherein the main control unit is configured to:
switch any one power supply module having a highest aging level in the first group from the operating mode to the non-operating mode when the load factor of the first group is less than a lower limit of a reference load factor range.

10. A direct current power supply system comprising the power supply control apparatus according to any one of claims 1 to 9.

11. A power supply control method comprising:

generating measurement data indicating a state of each of first to n-th power supply modules provided to supply direct current power to an electrical device;
generating monitoring information including at least one of aging level information or load factor information based on the measurement data, wherein among first to n-th aging levels of the aging level information, an i-th aging level indicates an aging level of an i-th power supply module among the first to n-th power supply modules, and among first to n-th load factors of the load factor information, an i-th load factor indicates a load factor of the i-th power supply module; and
controlling each of the first to n-th power supply modules into an operating mode or a non-operating mode based on the monitoring information,
wherein n is a natural number of 2 or greater, and i is a natural number of n or smaller.

12. The power supply control method according to claim 11,
wherein the step of generating the monitoring information comprises:

determining a temperature change amount of the i-th power supply module during a unit time based on the measurement data;
determining an aging level increase value of the i-th power supply module based on the temperature change amount; and
determining the i-th aging level based on the aging level increase value and a previous aging level of the i-th power supply module.

13. The power supply control method according to claim 11,
wherein the step of controlling each of the first to n-th power supply modules into the operating mode or the non-operating mode comprises:

classifying each power supply module in the operating mode among the first to n-th power supply modules into a first group; and
classifying each power supply module in the non-operating mode among the first to n-th power supply modules into a second group.

14. The power supply control method according to claim 13,
wherein the step of controlling each of the first to n-th power supply modules into the operating mode or the non-operating mode further comprises:
switching any one power supply module of the second group from the non-operating mode to the operating mode when the load factor of the first group exceeds an upper limit of a reference load factor range.

15. The power supply control method according to claim 13,
wherein the step of controlling each of the first to n-th power supply modules into the operating mode or the non-operating mode further comprises:
switching any one power supply module having a highest aging level in the first group from the operating mode to the non-operating mode when the load factor of the first group is less than a lower limit of a reference load factor range.

FIG. 1

Direct current power supply system(10)

FIG. 2

FIG. 3

FIG. 4

```
                    ┌─────────────┐
                    │    Start     │
                    └──────┬──────┘
                           │          ╭─S410
   ┌───────────────────────▼───────────────────────┐
   │   Collect measurement data indicating state of  │
   │    each of first to n-th power supply modules   │
   └───────────────────────┬───────────────────────┘
                           │          ╭─S420
   ┌───────────────────────▼───────────────────────┐
   │  Generate monitoring information including at   │
   │   east one of aging level information or load   │
   │              factor information                 │
   └───────────────────────┬───────────────────────┘
                           │          ╭─S430
   ┌───────────────────────▼───────────────────────┐
   │  Control each of first to n-th power supply     │
   │   modules into operating mode or non-operating  │
   │                    mode                         │
   └───────────────────────┬───────────────────────┘
                           │
                    ┌──────▼──────┐
                    │     End      │
                    └─────────────┘
```

FIG. 5

FIG. 6

Start

S610
Determine reference aging level

S630
Classify first to n-th power supply modules Classify first to n-th power supply modules

S620
Determine first to n-th aging level deviations

S640
Largest aging level deviation of first group≥Reference aging level deviation?

NO

YES

S650
Determine first target module and second target module

S660
Change first target module to non-operating mode and second target module to operating mode

End

FIG. 7

Start

S710

NO / Do two or more power supply modules in first group have same highest aging level?

YES

S730

Determine power supply module having highest aging level as first target module

S720

Determine any one power supply module having longest operation time, highest temperature or smallest module identification number as first target module

S730

NO / Do two or more power supply modules in second group have same lowest aging level?

YES

S750

Determine power supply module having lowest aging level as second target module

S740

Determine any one power supply module having shortest operation time, lowest temperature, smallest module identification number or longest idle time as second target module

End

FIG. 8

```
                    ┌─────────────┐
                    │    Start    │
                    └──────┬──────┘
                           │
                           ▼                           S810
    ╱─────────────────────────────────────────╲  NO   ┌──────┐
    ⟨  Load factor of first group >            ⟩─────▶│ S910 │
    ⟨  Upper limit of reference load factor range?⟩    └──────┘
    ╲─────────────────────────────────────────╱
                           │ YES
                           ▼                           S820
    ┌─────────────────────────────────────────────┐
    │  Determine module of interest in second group │
    └──────────────────────┬──────────────────────┘
                           │                           S830
                           ▼
    ┌─────────────────────────────────────────────┐
    │   Change module of interest to operating mode │
    └──────────────────────┬──────────────────────┘
                           │
                           ▼
                    ┌─────────────┐
                    │     End     │
                    └─────────────┘
```

FIG. 9

```
                          ┌─────────┐
                          │  Start  │
                          └────┬────┘
                               │
                               ▼                            S910
       ╱──────────────────────────────────────────────────╲  NO
      ╱        Load factor of first group <                 ╲────┐
      ╲     Lower limit of reference load factor range?     ╱    │
       ╲──────────────────────────────────────────────────╱     │
                               │ YES                             │
                               ▼                            S920 │
      ┌────────────────────────────────────────────────────┐    │
      │      Determine module of interest in first group    │    │
      └────────────────────────┬───────────────────────────┘    │
                               │                            S930 │
                               ▼                                 │
      ┌────────────────────────────────────────────────────┐    │
      │    Change module of interest to non-operating mode  │    │
      └────────────────────────┬───────────────────────────┘    │
                               │◄────────────────────────────────┘
                               ▼
                          ┌─────────┐
                          │   End   │
                          └─────────┘
```

FIG. 10

EP 4 749 877 A1

FIG. 11

Start

⌐S1110

Determine aging level increase value of i-th power supply module
by applying aging level estimation model to measurement data

⌐S1120

Determine aging level of i-th power supply module based on
aging level increase value and previous aging level

End

## INTERNATIONAL SEARCH REPORT

| International application No. |
|---|
| **PCT/KR2024/019392** |

| | |
|---|---|
| **A. CLASSIFICATION OF SUBJECT MATTER** | |
| **H02J 7/00**(2006.01)i; **G01R 31/392**(2019.01)i; **H02J 1/10**(2006.01)i | |
| According to International Patent Classification (IPC) or to both national classification and IPC | |

| **B. FIELDS SEARCHED** |
|---|
| Minimum documentation searched (classification system followed by classification symbols) |
| H02J 7/00(2006.01); G01R 31/367(2019.01); G01R 31/392(2019.01); G06N 3/08(2006.01); H02J 7/34(2006.01); H02J 7/35(2006.01); H02M 1/32(2007.01) |
| Documentation searched other than minimum documentation to the extent that such documents are included in the fields searched |
| Korean utility models and applications for utility models: IPC as above<br>Japanese utility models and applications for utility models: IPC as above |
| Electronic data base consulted during the international search (name of data base and, where practicable, search terms used) |
| eKOMPASS (KIPO internal) & keywords: 부하(load), 온도(temperature), 그룹(group), 전원 공급(power supply), 모니터링(monitoring) |

**C. DOCUMENTS CONSIDERED TO BE RELEVANT**

| Category* | Citation of document, with indication, where appropriate, of the relevant passages | Relevant to claim No. |
|---|---|---|
| X | KR 10-2613947 B1 (CHARMBITSIGN) 14 December 2023 (2023-12-14)<br>See paragraphs [0033]-[0097]; and figures 3a-4. | 1-3,10-12 |
| Y | | 4-9,13-15 |
| Y | KR 10-2020-0131676 A (KOREA AUTOMOTIVE TECHNOLOGY INSTITUTE) 24 November 2020 (2020-11-24)<br>See paragraphs [0049]-[0051] and [0057]-[0062]. | 4-9,13-15 |
| Y | KR 10-2178748 B1 (KOREA AUTOMOTIVE TECHNOLOGY INSTITUTE) 13 November 2020 (2020-11-13)<br>See paragraphs [0064]-[0065]. | 5-7 |
| A | KR 10-2011-0062852 A (SAMSUNG SDI CO., LTD.) 10 June 2011 (2011-06-10)<br>See paragraphs [0050]-[0052]. | 1-15 |

| ✓ Further documents are listed in the continuation of Box C. | ✓ See patent family annex. |
|---|---|

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **17 March 2025** | **17 March 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

International application No.

**PCT/KR2024/019392**

### C.    DOCUMENTS CONSIDERED TO BE RELEVANT

| Category* | Citation of document, with indication, where appropriate, of the relevant passages | Relevant to claim No. |
|---|---|---|
| A | KR 10-2023-0055249 A (KYUNGPOOK NATIONAL UNIVERSITY INDUSTRY-ACADEMIC COOPERATION FOUNDATION) 25 April 2023 (2023-04-25)<br>See paragraphs [0046]-[0052]. | 1-15 |

Form PCT/ISA/210 (second sheet) (July 2022)

## INTERNATIONAL SEARCH REPORT
### Information on patent family members

International application No.

**PCT/KR2024/019392**

| Patent document cited in search report | | | Publication date (day/month/year) | Patent family member(s) | | | Publication date (day/month/year) |
|---|---|---|---|---|---|---|---|
| KR | 10-2613947 | B1 | 14 December 2023 | None | | | |
| KR | 10-2020-0131676 | A | 24 November 2020 | KR | 10-2259852 | B1 | 03 June 2021 |
| KR | 10-2178748 | B1 | 13 November 2020 | None | | | |
| KR | 10-2011-0062852 | A | 10 June 2011 | KR | 10-1093956 | B1 | 15 December 2011 |
| | | | | US | 2011-0133556 | A1 | 09 June 2011 |
| | | | | US | 8552591 | B2 | 08 October 2013 |
| KR | 10-2023-0055249 | A | 25 April 2023 | KR | 10-2703517 | B1 | 06 September 2024 |

Form PCT/ISA/210 (patent family annex) (July 2022)

**EP 4 749 877 A1**

**Patent documents cited in the description**

- KR 1020230188796
- KR 1020240170006